# EUROPEAN PATENT APPLICATION

(11) **EP 4 075 484 A1**
(43) Date of publication of application: **19.10.2022**
(21) Application number: 21167842.0
(22) Date of filing: 12.04.2021
(51) Int. Cl.: H01L 21/56, H01L 23/04, H01L 23/053, H01L 25/07, H01L 23/24

(54) **POWER SEMICONDUCTOR MODULE COMPRISING MOLDED BODY AND METHOD FOR PRODUCING A POWER SEMICONDUCTOR MODULE**

(71) Applicant: Hitachi Energy Switzerland AG, 5400 Baden (CH)
(72) Inventor: KICIN, Slavo, 8049 Zürich (CH); GUILLON, David, 8857 Vorderthal (CH); BEYER, Harald, 5600 Lenzburg (CH); SALVATORE, Giovanni, 34170 Gorizia (IT)
(74) Representative: Epping - Hermann - Fischer

(57) **Abstract**

A power semiconductor module (10) is provided. The power semiconductor module (10) comprises a carrier (1), at least one module component (3), a housing frame (4) and an encapsulation body (2), wherein the module component (3) is arranged on the carrier (1) and is laterally surrounded by the housing frame (4). The housing frame (4) is arranged on the carrier (1) and vertically projects beyond the carrier (1) and the module component (3). The housing frame (4) has a housing frame opening (4C) in which the module component (3) is arranged, wherein the housing frame opening (4C) is filled with the encapsulation body (2). The housing frame (4) has at least one exterior side surface (4S) which is not covered by the encapsulation body (2), wherein the encapsulation body (2) is a molded body.

Moreover, a method for producing such a power semiconductor module (10) is provided.

## Description

The present disclosure relates to a power semiconductor module comprising a molded body and a method for producing a power semiconductor module.

So far, a typical industrial power electronic module, exploits silicone gel layer as an electric insulation which also acts for environmental and mechanical protecting the power electronic module. The silicone gel layer can be formed during one of the last manufacturing steps using a potting process. However, requirements on reliability and environmental robustness of the power semiconductor modules are constantly increasing. Therefore, new solutions or new module concepts are required by power module manufacturers. Alternatively, modules may have a hard encapsulation made of potting resin material, for instance epoxy material.

Embodiments of the disclosure relate to a mechanically stable power semiconductor module having high robustness against environmental and external mechanical influences. Further embodiments of the disclosure relate to a simplified and efficient method for producing a power semiconductor module.

Embodiments of the disclosure address the above shortcomings in the art in whole or in part. Further embodiments of the power semiconductor module and of the method for producing the power semiconductor module are subject matter of the further claims.

According to an embodiment of a power semiconductor module, the power semiconductor module comprises a carrier, at least one module component, a housing frame and an encapsulation body, wherein the module component is arranged on the carrier and is laterally surrounded by the housing frame. The housing frame is arranged on the carrier and vertically projects beyond the carrier and the module component. The housing frame has a housing frame opening in which the module component is arranged, wherein the housing frame opening is filled with the encapsulation body. The housing frame has at least one exterior side surface which is not covered by the encapsulation body. The encapsulation body is a molded body.

A vertical direction is understood to mean a direction which is directed perpendicular to a main extension surface of the carrier. A lateral direction is understood to mean a direction which is parallel to the main extension surface of the carrier. The vertical direction and the lateral direction are orthogonal to each other. The carrier can be a base plate or a substrate. The base plate can have an electrically conductive or insulating basic body or it may comprise a metal base, an insulating layer and circuit metallization on its top and/or rear surface. The substrate may comprise for instance electrically insulating body (e.g. ceramic) and circuit metallization on the top. Metallic layer may be also formed at the rear surface of the substrate. Additionally, a substrate may be mounted on the baseplate e.g. by soldering.

A molded body is understood to mean a body made of a mold material. Such a molded body can be formed by a molding process, for instance by injection molding, transfer molding, compression molding, film-assisted molding or the like. The molding process can be performed by using a molding tool. In general, a molded body differs from a resin body which is formed by a process different from a molding process, for instance by a potting process. The differences between a molded body and a potting resin body or between a molded body and a body formed by a potting process can be reflected in their characteristic properties with regard to for instance rigidity, material structure or material composition. Thus, the molded body is not a potting resin body, i.e. a body made of a resin material or made by a potting process. Differentiating characteristics between the molded body and the potting resin may be reflected by geometric features like formation of meniscus of molded material which is available after carrying a potting process but not after carrying a molding process. Hence, the molded body can be free of meniscus-like geometrical structures.

For instance, the mold material for forming the encapsulation body is an electrically insulating material. The electrically insulating material may comprise or made of a thermoset material or a thermoplastic material. The thermoset material may be made on the basis of an epoxy material. The thermoplastic material may comprise one or more materials of the group of polyetherimide (PEI), polyether-sulfone (PES), polyphenylene-sulfide (PPS) or polyamide-imide (PAI). Thermoplastic materials can me melt by application of pressure and heat during a molding process or lamination and can be reversibly hardened upon cooling and pressure release.

The mold material may comprise or may be made of a polymer material. The mold material may comprise at least one of filled or unfilled polymer materials, for instance at least one of a filled or unfilled thermoplastic material, a filled or unfilled thermoset material, a filled or unfilled laminate, a fiber-reinforced laminate, a fiber-reinforced polymer laminate, and a fiber-reinforced polymer laminated with filler particles.

As an example, the molded body is formed from an electrically insulating matrix material such as an epoxy material. It is possible that for enhancing the stability and robustness of the molded body, fillers can be embedded within the matrix material. The fillers may be in form of particles or in form of reinforcing fibers. The fillers may also be used for adjusting the coefficient of thermal expansion (CTE), or for improvement of thermal conductivity of the encapsulation body. The fillers can have a lower or greater coefficient of thermal expansion in comparison to the matrix material.

Moreover, using the fillers, the viscosity of the material of the encapsulation body can be adjusted during the process of forming the encapsulation body, resulting in a simplified method for applying the encapsulation body into the housing frame opening. For instance, a mold material can be used for forming the encapsulation body, wherein the mold material comprises a matrix material and fillers embedded therein for enhancing the viscosity of the mold material. In other words, the matrix material containing the fillers may have higher viscosity than the matrix material without the fillers. This would simplify the process of forming the encapsulation body.

According to a further embodiment of the power semiconductor module, a filler content of the encapsulation body is at least 60 or at least 70 volume-% or weight-%. The filler content can be between 60 and 95 volume-% or weight-%, for instance between 70 and 90 volume-% or weight-%, between 70 and 85 volume-% or weight-%, between 70 and 80 volume-% or weight-% or between 70 and 75 volume-% or weight-%, or between 60 and 75 volume-% or weight-%, inclusive. The disclosure, however, is not restricted to the case that the filler content of the encapsulation body is at least 60 volume-% or weight-%. The filler content of the encapsulation body may be also less than 60 volume-% or weight-%, for instance between 10 and 60 volume-% or weight-%, or between 10 and 50 volume-% or weight-% or between 10 and 30 volume-% or weight-%. For instance, when using injection molding, the filler content may be around 10 volume-% or weight-%.

According to a further embodiment of the power semiconductor module, the power semiconductor module comprises a plurality of module components arranged on the carrier, wherein in a top view, the encapsulation body covers the module components for instance completely, fills interspaces between the module components and protects the module components from environmental and external mechanical influences. In lateral direction, the encapsulation body can completely surround the at least one module component or the plurality of module components. The encapsulation body is formed from an electrically insulating material. Such an insulating material can be an opaque material for instance to light in visible spectral ranges. The material of the encapsulation body, however, is not restricted to opaque material but can be radiation-transmissive or partly radiation-transmissive. The module components may be power semiconductor devices or substrates with mounted power semiconductor devices, but are not restricted thereto.

According to an embodiment of a method for producing a power semiconductor module, for instance a power semiconductor module described in this disclosure, the method comprises applying a molding tool on a top surface of the housing frame, thereby forming a direct contact between the molding tool and the top surface of the housing frame. For instance, the top surface of the housing frame is configured to receive the molding tool. The housing frame opening is filled with a mold material for forming an encapsulation body by a molding process using the molding tool. The housing frame has at least one exterior side surface which is not covered by the mold material.

For instance, at least two or three exterior side surfaces or all exterior side surfaces of the housing frame are not covered by the mold material or by the encapsulation body. It is possible that within production tolerances, the top surface of the housing frame is not covered by the mold material or by the encapsulation body. The encapsulation body formed by the molding process for instance using the molding tool can be referred to as a molded body. The molding process can be injection molding, transfer molding, foil-assisted molding or other similar molding methods.

According to a further embodiment of the method, the mold material comprises a matrix material and fillers embedded therein. For example, the matrix material comprising the fillers has a higher viscosity than the matrix material without the fillers. Due to increased viscosity of the mold material, the process of applying the mold material onto the module component/s located in the housing frame opening can be performed in a simplified and precise manner. In general, for instance in the presence of small gaps, using a molding process is more effective than using a potting process, since the mold process is carried out inter alia by application of pressure so that a proper filling of even small gaps can be achieved.

According to a further embodiment of the method, the mold material is applied directly onto the module component/s and in top view, completely covers the module component/s. In top view, a front side of the power semiconductor module can be partially formed by a surface of the encapsulation body. In other words, in a plane view of the power semiconductor module, it is possible for the encapsulation body to be not covered at all or to be not covered at least in places by any other layer of the power semiconductor module. At least in regions of the housing frame opening, the encapsulation body can be the outermost layer of the power semiconductor module.

The encapsulation body can partially or completely fill the housing frame opening. In top view, the encapsulation body can completely cover a bottom surface of the housing frame opening. For instance, the bottom surface of the housing frame opening is configured to receive one module component or a plurality of the module components. In this sense, the bottom surface of the housing frame opening can be referred to as a mounting area of the carrier. In lateral directions, such a mounting area is surrounded and thus delimited by the housing frame.

Forming the encapsulation body as a molded body, the reliability and environmental robustness of the power semiconductor module are improved. Using the mold material for instance with fillers embedded therein, the encapsulation body has improved properties, for instance with regard to environmental protection, mechanical robustness, matching of coefficients of thermal expansion or improved properties with regard to heat dissipation. Moreover, using the molding process, production costs may be reduced, also with regard to the price of raw material even compared to potting material.

According to a further embodiment of the method or of the power semiconductor module, the top surface of the housing frame is configured to receive the molding tool. Regarding the geometrical size and structure, the top surface of the housing frame and a contact surface of the molding tool can be adapted to each other for achieving a tightly adjusted and for instance aligned arrangement of the molding tool on the top surface. For example, the top surface comprises one plane region or several plane regions for enabling a tight connection of the molding tool to the top surface of the housing frame.

The present disclosure comprises several aspects of a power semiconductor module and of a method for producing the power semiconductor module on the basis of their embodiments and examples. Every feature described with respect to one of the aspects is also disclosed herein with respect to the other aspect, even if the respective feature is not explicitly mentioned in the context of the specific aspect. For example, the method described in this disclosure is directed to the production of any of the embodiments of the power semiconductor module described here. Thus, features and advantages described in connection with the power semiconductor module can be used for the method, and vice versa.

While the disclosure is amenable to various modifications and alternative forms, specifics thereof are shown by way of example in the figures and will be described in detail. It should be understood, however, that the intention is not to limit the disclosure to the particular described embodiments and examples. On the contrary, the intention is to cover all modifications, equivalents, and alternatives falling within the scope of the disclosure defined by the appended claims.

The accompanying figures are included to provide a further understanding. In the figures, elements of the same structure and/or functionality may be assigned to the same reference signs. It is to be understood that the examples shown in the figures are illustrative representations and are not necessarily true to scale.
Figure 1A shows a top view of a power semiconductor module according to an example.
Figure 1B shows a sectional view of a power semiconductor module during the step of applying a mold material for forming an encapsulation body according to an example.
Figure 1C shows a sectional view of a power semiconductor module comprising the encapsulation body according to a further example.
Figure 2 shows a top view of a power semiconductor module according to a further example.

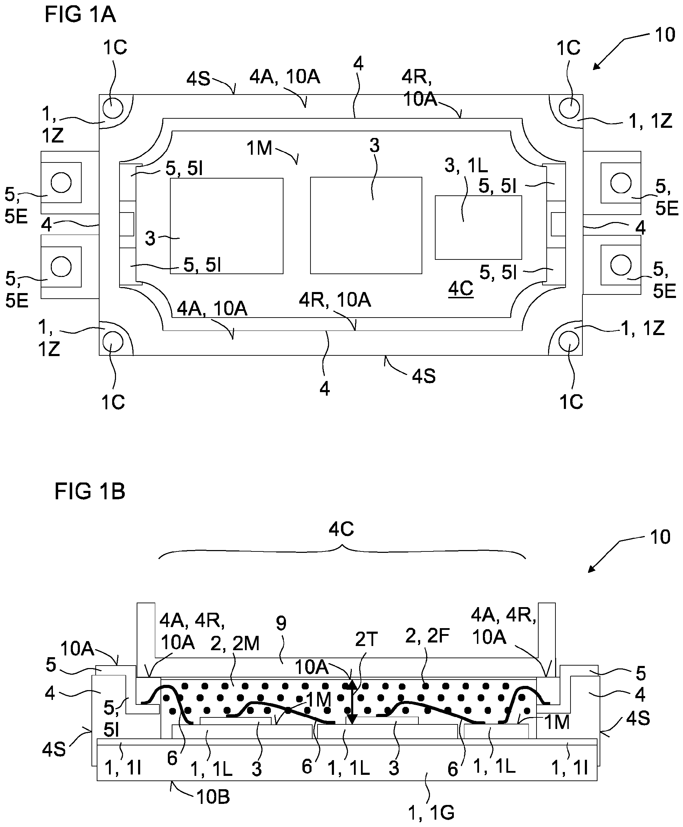

Figure 1A shows in top view an example of a power semiconductor module 10 according to an exemplary embodiment. The power semiconductor module 10 comprises a carrier 1, at least one module component 3 and a housing frame 4, wherein the module component 3 is arranged on the carrier 1 and is laterally surrounded by the housing frame 4. The power semiconductor module 10 can comprise at least two module components 3 or a plurality of module components 3. The housing frame 4 is arranged on the carrier 1 and vertically projects beyond the carrier 1 and the module component/s 3. The housing frame 4 and the carrier 1 can be formed from different materials.

The carrier 1 can comprise a basic body 1G as shown for instance in Figure 1B. A rear side of the carrier 1 or of the basic body 1G forms a rear side 10B of the power semiconductor module 10. Essentially, Figure 1B can be considered as showing a sectional view of the power semiconductor module 10 shown in Figure 1A. In contrast to Figure 1B, however, for the sake of clarity, in Figure 1A, an encapsulation body 2 is not shown. The subject matter shown in Figure 1A can also be considered as the power semiconductor module 10 in a stadium before the encapsulation body 2 is formed.

The basic body 1G can be made of metal or metal alloy. For example, the basic body 1G is made of Cu or Al, or corresponding alloy. Alternatively, it is also possible that the basic body 1G is made of a composite material, for instance from aluminum silicon carbide (AlSiC) or magnesium silicon carbide (MgSiC) or from a ceramic material. The basic body 1G, however, is not restricted to the materials mentioned above.

In Figure 1B, the carrier 1 can be formed as a base plate. The base plate can be an integrated metallic or ceramic substrate comprising the basic body 1G, an intermediate layer 1I and/or conductive layers 1L. The intermediate layer 1I is for instance an electrically insulating layer.

In deviation from Figure 1B, the carrier 1 can be an insulating or conductive substrate formed as the basic body 1G. The component module 3 can be arranged on the carrier 1. The component module 3 can comprise a component substrate, for instance a ceramic component substrate, and a semiconductor device, wherein the component substrate can have top and bottom metallization layers. The semiconductor device can be arranged on the component substrate, for instance on the top metallization layer.

In deviation from Figure 1B, it is also possible that the basic body 1G is an insulating substrate. The insulating substrate can be a ceramic body or resin insulating layer. In this case, it is possible that the intermediate layer 1I is dispensed with. A top metallization layer, which can be one of the conductive layers 1L, is arranged on a top surface of the basic body 1G. The component module 3 can be arranged on the top metallization layer. Optionally, a rear-side metallization layer can be arranged on a rear side of the basic body 1G.

In Figure 1B, in vertical direction, the intermediate layer 1I is arranged between the basic body 1G and the conductive layers 1L. If the basic body 1G is formed from an electrically insulating material, the conductive layers 1L can be formed directly on the basic body 1G.

The intermediate layer 1I can be an insulating layer or a connection layer, wherein the intermediate layer 1I in form of the connection layer is used to fix the conductive layers 1L on the basic body 1G. One main purpose of the intermediate layer 1I is electrical insulation. In lateral directions, the conductive layers 1L can be spatially separated from each other. As shown in Figure 1B, the intermediate layer 1I can be used to fix the housing frame 4 on the carrier 1, for instance on the basic body 1G. The intermediate layer 1I can comprise an adhesive material or a resin material. The intermediate layer 1I may be used for attachment of the housing frame 4. As an alternative, it is possible that the housing frame 4 is formed directly on the carrier 1. A stable mechanical connection between the housing frame 4 and the carrier 1 can be formed during a curing process. However, other joining methods are also possible, for instance method using a joining material like glue, or other methods like screwing and/or application of a sealing layer.

The housing frame 4 can be made of an electrically insulating material. For example, the housing frame 4 is of one piece form. "A housing frame formed in one piece" means for instance that the housing frame 4 is made of a single piece. For example, the housing frame 4 does not comprise separate parts connected to each other for instance using a connecting material. The housing frame 4 rather comprises only integral parts integrally connected with each other, i.e. without using any additional connecting material. Such integral parts of the housing frame 4 can be formed from the same material. The disclosure, however, is not restricted to the case that housing frame formed in one piece. It is also possible that the housing frame may comprise a frame-part and a cover-part, wherein the cover-part is formed or fixed on the underlying frame-part.

The housing frame 4 can be formed as a surrounding, for instance continuous wall-structure on the carrier 1. In lateral directions, the housing frame 4 extends along all edges of the carrier 1. In top view, the housing frame 4 has a housing frame opening 4C. The module component/s 3 are arranged in the housing frame opening 4C. For example, all module component/s 3 of the power semiconductor module 10 are arranged within the housing frame opening 4C. The module component 3 can be an electric or electronic component. Such component can comprises one or many of: electronic chip, semiconductor chip, embedded semiconductor chip, substrate with one or several chips arranged thereon, diode, component comprising Si and/or SiC, discrete devices like resistor, capacitor, inductive component and/or transistor like IGBT, MOSFET etc.

The housing frame opening 4C has a bottom surface 1M surrounded by the housing frame 4. The component/s 3 is/are fixed on the bottom surface 1M. For fixing the component/s 3 on the bottom surface 1M, a soldering, sintering, gluing, diffusion bonding or a transition liquid phase bonding process can be used. The bottom surface 1M of the housing frame opening 4C is thus configured for receiving module components 3. In this sense, the bottom surface 1M can be referred to as a mounting area for the module components 3. As shown in Figure 1B, the bottom surface 1M of the housing frame opening 4C is formed in places by surfaces of the intermediate layer 1I and/or in places by surfaces of the conductive layers 1L. For instance, the bottom surface 1M comprises a plurality of separated joining areas for receiving the module component/s 3, wherein the separated joining areas can be electrically conductive surfaces for instance of the spatially separated conductive layers 1L.

Outside the housing frame opening 4C, i.e. outside the housing frame 4, the carrier 1 can have at least one carrier opening 1C which is configured for instance for receiving a screw for fixing the power semiconductor module 10 to an external carrier, for example, to a cooler or a heat sink. Along the vertical direction, the carrier opening 1C may extend throughout the basic body 1G or throughout the carrier 1. Thus, surfaces of the carrier 1 located outside the housing frame opening 4C shall not be referred to as mounting area 1M for receiving the module components 3 but are rather referred to as assembly surface 1Z for fixing the carrier 1 or the power semiconductor module 10 to an external carrier.

According to Figure 1A, the carrier 1 has four carrier openings 1C arranged at four corners of the carrier 1. At the corners of the carrier 1, the housing frame 4 is curved and adapted to the geometry of the carrier openings 1C of the carrier 1. In deviation from Figure 1A, the carrier openings 1C can be formed at locations other than the corners of the carrier 1. The carrier opening/s 1C, however, is/are located outside the housing frame opening 4C.

Thus, according to at least one example of the power semiconductor module 10, the carrier 1 has at least one carrier opening 1C or more than one carrier opening 1C which is/are configured for receiving at least one screw for fixing the power semiconductor module 10 for instance on an external carrier. For example, all the carrier opening/s 1C are located outside the housing frame 4.

As shown in Figure 1A, the power semiconductor module 10 comprises at least one terminal 5 for instance for electrically connecting the module component 3, for example, to an external electrical source. As shown in Figure 1B, the terminal 5 is partly embedded within the housing frame 4 and is accessible on a top surface 4A of the housing frame 4 or outside the housing frame 4. The terminal 5 can have an exterior access area 5E which is accessible from outside, wherein the exterior access area 5E of the terminal 5 is located outside the housing frame opening 4C. The exterior access area 5E can have a through-hole for instance for receiving an electrical connection, for example a mounting screw which is used to mechanically attached the module to a bus-bar, cable et cetera. Usually, a good mechanical connection also results in a good electrical connection. In top view, the exterior access area 5E can be located to the side of the housing frame 4 and/or of the basic body 1G of the carrier 1.

As shown in Figures 1A and 1B, the power semiconductor module 10 can have a plurality of such terminals 5, for instance two or four or more than four such terminals 5. Two different terminals 5 may be assigned to different electrical polarities of the power semiconductor module 10. The two different terminals 5 can be arranged on opposite edge regions or on the same edge region of the carrier 1. Moreover, control or signal terminals may be arranged in the module housing.

Thus, according to at least one example of the power semiconductor module 10, it comprises a least one terminal 5 which is partly embedded within the housing frame 4 and is accessible for instance on the top surface 4A of the housing frame 4. The terminal 5 is accessible at the exterior access area 5E.

Inside the housing frame opening 4C, the terminal 5 can have an interior access area 5I for receiving a wiring structure 6, for instance for receiving some parts of the wiring structure 6. The wiring structure 6 can comprise a plurality of wires, for instance bond wires. Via the wiring structure 6, the interior access area 5I of the terminal 5 can be electrically connected to one or several conductive layers 1L and/or to one or several module components 3. Furthermore, the wiring structure 6 can be used for electrically connecting the conductive layers 1L and/or the module components 3 among each other. The terminals 5 can be formed as main power or auxiliary terminals which are part of a housing of the power semiconductor module 10. The terminals 5 can be electrically connected to one or several conductive layers 1L or to one or several module components 3 for instance using wire-bonding or welding. In some cases, however, the terminals 5 may be directly connected to substrates e.g. by soldering or welding. Moreover, the terminals 5 can also be arranged on other housing parts. Furthermore, the terminals 5 may be pin-shaped auxiliary or control terminals located on lateral sides of the housing. These terminals are extending vertically from peripheral regions of the top surface.

The housing frame 4 has a top surface 4A which is configured to receive a molding tool 9. For example, the top surface 4A of the housing frame 4 partially forms a front side 10A of the power semiconductor module 10. Thus, the top surface 4A of the housing frame 4 is freely accessible from outside.

The top surface 4A, for instance a part of the top surface 4A being a contact surface 4R of the housing frame 4, is adapted to the size and/or geometrical structure of a contact surface of the molding tool 9 for achieving a tightly adjusted and for instance aligned arrangement of the molding tool 9 on the top surface 4A. For example, the top surface 4A or the contact surface 4R of the surface 4A comprises one plane region or several plane regions for enabling a tight connection between the contact surface of the molding tool 9 and the top surface 4A of the housing frame 4.

In top view, the top surface 4A, for instance the contact surface 4R of the top surface 4A, which is configured to receive the molding tool 9, runs between the exterior access areas 5E and the interior access areas 5I of the terminals 5, and/or the exterior access areas 5E and the housing frame opening. In other words, the exterior access area 5E and the interior access area 5I of the same terminal 5 are located on different sides of the top surface 4A or on different sides of the contact surface 4R of the top surface 4A of the housing frame 4. Thus, the exterior access areas 5E and the interior access areas 5I of the terminals 5 will not be damaged when the molding tool 9 is arranged on the top surface 4A. In top view, the contact surface 4R can completely surround the housing frame opening 4C.

Usually, the orientations and positions of terminals 5 would result in an extremely complex molding fixture regarding the forming the encapsulation body 2 as a molded body within the housing frame opening 4C. The molding process would require several additional manufacturing steps. Moreover, requirements on high precision of the molding process cannot be always fulfilled. Using the housing frame 4 having a top surface 4A or the contact surface 4R configured for receiving a molding tool 9, however, would significantly simplify the molding process which can be performed in a precise manner.

Figure 1B illustrates a method step for forming the encapsulation body 2 as a molded body. The molding tool 9 can be arranged in a predetermined position on the top surface 4A of the housing frame 4, for instance directly on the contact surface 4R. Since only the top surface 4A or the contact surface 4R shall be adapted to the molding tool 9, the typical housing frame 4 requires only a minor modification, for instance by preparing a flat top surface, for enabling a tight connection between the molding tool 9 and the housing frame 4. This solution can be applied to any type of the power semiconductor module 10 if the molding process is difficult or hardly possible without using the housing frame 4.

According to Figure 1B, the housing frame opening 4C is filled with a mold material for forming the encapsulation body 2 using a molding process. Since the housing frame 4 is arranged on the carrier 1 and vertically projects beyond the carrier 1 and the module component/s 3, it is possible that only the housing frame opening 4C is filled with the mold material. The encapsulation body 2 formed in this way can be referred to as molded body. For example, at least one, at least two exterior side surfaces 4S or all exterior side surfaces 4S of the housing frame 4 are not covered by the material of the encapsulation body 2.

According to an example of the method, the mold material comprises a matrix material 2M and fillers 2F embedded therein, wherein the matrix material 2M containing the fillers 2F has higher viscosity than the matrix material 2M without the fillers 2F. For example, the matrix material 2M is an epoxy material. The matrix material 2M containing the fillers 2F have better properties for instance with regard to robustness and thermal conductivity or with regard to adjustment of coefficients of thermal expansion. The filler content of the mold material or of the encapsulation body 2 can be at least 60, 65, 70 or at least 75 % volume-% or weight-%.

Thus, according to at least one example of the power semiconductor module 10, the encapsulation body 2 comprises a matrix material 2M and fillers 2F. For instance, a filler content of the encapsulation body 2 is at least 60 volume-% or weight-%. It is also possible that the filler content of the encapsulation body 2 is between 10 and 60 or between 10 and 50 volume-% or weight-%.

According to at least one example of the method, the mold material is applied directly onto the module component/s 3 and in top view, completely covers the module component/s 3. The molded body can completely cover the bottom surface 1M of the housing frame opening 4C. The exterior side surfaces 4S of the housing frame 4 and/or the assembly surface 1Z outside the housing frame opening 4C, however, can be void of the mold material, i.e. void of the material of the encapsulation body 2. Since the top surface 4A of the housing frame 4 is covered by the molding tool 9 during the molding process, the top surface 4A can be at least partially or completely void of the mold material, i.e. the material of the encapsulation body 2.

According to at least one example of the power semiconductor module 10, the encapsulation body 2 directly adjoins the module component 3 and in top view, can completely cover the module component 3. In a top view, the front side 10A of the power semiconductor module 10 can be partially formed by a surface of the encapsulation body 2.

For instance, the formation of the encapsulation body 2 is performed after the module components 3 have been wired, i.e. after the wiring structure 6 has been formed. Thus, the interior access area/s 5I of the terminal/s 5 located within the housing frame opening 4C can be at least partially or completely covered by the material of the encapsulation body 2. It is possible that the wiring structure 6 within the housing frame opening is at least partially or completely covered by the material of the encapsulation body 2.

According to at least one example of the power semiconductor module 10, the encapsulation body 2 is located within the housing frame opening 4C or partly on the housing frame 4 but not outside the housing frame 4. For instance, in top view, the encapsulation body 2 completely covers the housing frame opening 4C. An assembly surface 1Z outside the housing frame opening 4C is typically not covered by a material of the encapsulation body 2.

According to at least one example of the method, the housing frame opening 4C is partially or completely filled with the mold material. In a top view, the front side 10A of the power semiconductor module 10 is partially formed by a surface of the encapsulation body 2.

Along the vertical direction, the encapsulation body 2 has a vertical thickness 2T which can be between 1 mm and 40 mm inclusive, between 1 mm and 20 mm inclusive, for instance between 1 mm and 15 mm, between 1 mm and 10 mm or between 3 mm and 20 mm, between 5 mm and 20 mm or between 5 mm and 15 mm, inclusive. For example, the thickness 2T of the encapsulation body 2 is 10 mm ± 3 mm.

If the housing frame opening 4C is completely filled by the mold material, the vertical thickness 2T of the encapsulation body 2 is at least as large as a vertical depth of the housing frame opening 4C or larger than the vertical depth of the housing frame opening 4C. In the latter case, the encapsulation body 2 can vertically project beyond the top surface 4A of the housing frame 4. If the housing frame opening 4C is partially filled by the mold material, the vertical thickness 2T of the encapsulation body 2 is smaller than vertical depth of the housing frame opening 4C, for example by 4 mm ± 2 mm smaller than vertical depth of the housing frame opening 4C. Deviating from this, it is also possible that the housing frame opening 4C of the housing frame 4 is completely filled with the mold material, wherein the vertical thickness 2T of the encapsulation body 2 is larger than the vertical depth of the housing frame opening 4C.

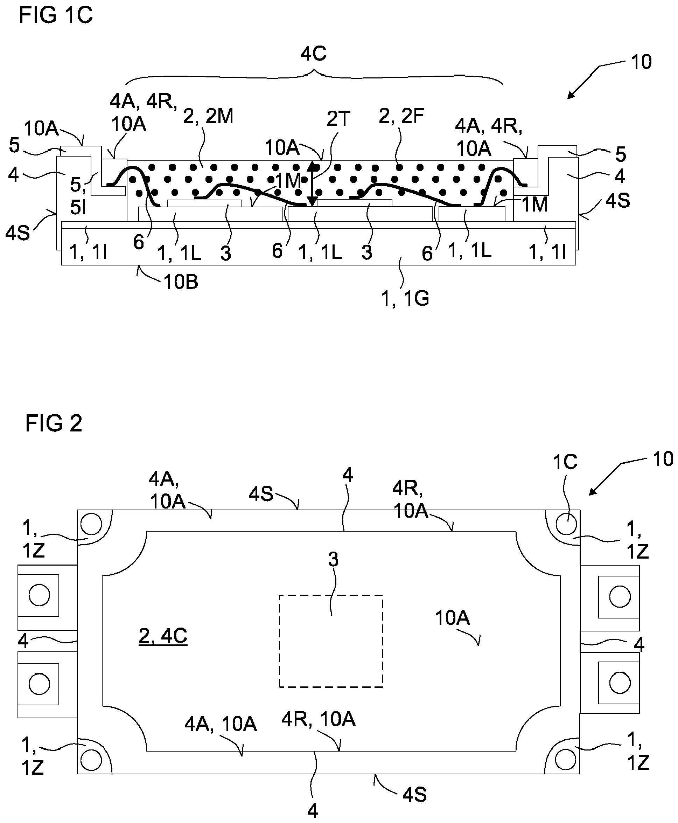

Figure 1C shows another example of the power semiconductor module 10 after the molding tool 9 has been removed. The power semiconductor module 10 shown in Figure 1C essentially corresponds to the power semiconductor module 10 shown in Figure 1B. In contrast, the housing frame opening 4C is not fully filled by the encapsulation body 2. Apart from that all features described in connection with the power semiconductor module 10 shown in Figure 1B or 1A can be applied to the power semiconductor module 10 shown in Figure 1C.

Figure 2 shows another example of the power semiconductor module 10. The power semiconductor module 10 shown in Figure 2 essentially corresponds to the power semiconductor module 10 shown in Figure 1A, 1B or 1C. In contrary to Figure 1A, for example, the encapsulation body 2 within the housing frame opening 4C is shown explicitly. Moreover, as shown in Figure 2, the power semiconductor module 10 can comprise at least one module component 3 or only one module component 3. It is, however, possible that the power semiconductor module 10 has more than one module component 3. Apart from that all features described in connection with the power semiconductor module 10 shown in Figures 1A, 1B and 1C can be applied to the power semiconductor module 10 shown in Figure 2.

According to at least one example of the power semiconductor module 10, the top surface 4A, for instance the contact surface 4R as part of the top surface 4A, of the housing frame 4 is configured to receive the molding tool 9. The top surface 4A can comprise one plane region or several plane regions for enabling a tight connection of the molding tool 9. For instance, the top surface 4A or at least the contact surface 4R is not covered by a material of the encapsulation body 2. The encapsulation body 2 can made from an opaque material and is formed to be not radiation-transmissive for instance with respect to light in visible spectral ranges. Deviating from this, the encapsulation body 2 can be radiation-transmissive or partly radiation-transmissive.

The embodiments or examples shown in the figures as stated represent exemplary embodiments of the improved power semiconductor module or improved method for producing a power semiconductor module; therefore, they do not constitute a complete list of all embodiments or examples according to the improved power semiconductor module or method. Actual arrangements of the power semiconductor module or method may vary from the exemplary embodiments described above.

### Reference signs

- 10: power semiconductor module
- 10A: front side of the power semiconductor module
- 10B: rear side of the power semiconductor module
- 1: carrier
- 1C: carrier opening of the carrier
- 1G: basic body of the carrier
- 1I: intermediate layer, insulating layer, connection layer
- 1M: bottom surface of the housing frame opening
- 1L: conductive layer
- 1Z: assembly surface
- 2: encapsulation body
- 2F: filler of the encapsulation body
- 2M: matrix material of the encapsulation body
- 2T: vertical thickness of the encapsulation body
- 3: module component
- 4: housing frame
- 4A: top surface of the housing frame
- 4C: housing frame opening of the housing frame
- 4S: exterior side surface of the housing frame
- 5: terminal
- 5E: exterior access area of the terminal
- 5I: interior access area of the terminal
- 6: wiring structure
- 9: molding tool

## Claims

1. A power semiconductor module (10) comprising a carrier (1), at least one module component (3), a housing frame (4) and an encapsulation body (2), wherein
- the module component (3) is arranged on the carrier (1) and is laterally surrounded by the housing frame (4),
- the housing frame (4) is arranged on the carrier (1) and vertically projects beyond the carrier (1) and the module component (3),
- the housing frame (4) has a housing frame opening (4C) in which the module component (3) is arranged, the housing frame opening (4C) being at least partly filled with the encapsulation body (2),
- the housing frame (4) has at least one exterior side surface (4S) which is not covered by the encapsulation body (2), and
- the encapsulation body (2) is a molded body.

2. The power semiconductor module (10) according to claim 1, wherein a top surface (4A) of the housing frame (4) is configured to receive a molding tool (9).

3. The power semiconductor module (10) according to claim 1, wherein a top surface (4A) of the housing frame (4) comprises one plane region or several plane regions for enabling a tight connection to a molding tool (9).

4. The power semiconductor module (10) according to claim 1, wherein a top surface (4A) or at least part of a top surface (4A) of the housing frame (4) is not covered by a material of the encapsulation body (2).

5. The power semiconductor module (10) according to any of previous claims, wherein
the carrier (1) is a base plate or comprises an insulating substrate.

6. The power semiconductor module (10) according to any of previous claims, wherein the encapsulation body (2) comprises a matrix material (2M) and fillers (2F).

7. The power semiconductor module (10) according to claim 6, wherein a filler content of the encapsulation body (2) is at least 60 volume-% or weight-%.

8. The power semiconductor module (10) according to claim 6, wherein a filler content of the encapsulation body (2) is between 10 and 60 volume-% or weight-%.

9. The power semiconductor module (10) according to any of previous claims, wherein the encapsulation body (2) is located only within the housing frame opening (4C), or within the housing frame opening (4C) and partly on the housing frame (4) but not outside the housing frame (4).

10. The power semiconductor module (10) according to any of previous claims, comprising a least a terminal (5) which is partly embedded within the housing frame (4) and is accessible outside the housing frame opening (4C).

11. The power semiconductor module (10) according to any of previous claims, wherein the carrier (1) has at least one carrier opening (1C) which is configured for receiving a screw for fixing the power semiconductor module (10) on an external carrier, the at least one carrier opening (1C) being located outside the housing frame (4).

12. The power semiconductor module (10) according to any of previous claims, wherein
- the encapsulation body (2) directly adjoins the module component (3) and in top view, completely covers the module component (3), and
- in a top view, a front side (10A) of the power semiconductor module (10) is partially formed by a surface of the encapsulation body (2).

13. A method for producing a power semiconductor module (10) comprising a carrier (1), at least one module component (3) and a housing frame (4), wherein
- the module component (3) is arranged on the carrier (1) and is laterally surrounded by the housing frame (4),
- the housing frame (4) is arranged on the carrier (1) and vertically projects beyond the carrier (1) and the module component (3),
- the housing frame (4) has an housing frame opening (4C) in which the module component (3) is arranged, and
- a top surface (4A) of the housing frame (4) is configured to receive a molding tool (9),
wherein the method comprises:
- applying the molding tool (9) on the top surface (4A) of the housing frame (4), thereby forming a direct contact between the molding tool (9) and the top surface (4A) of the housing frame (4), and
- filling the housing frame opening (4C) with a mold material (2M, 2F) for forming an encapsulation body (2) by a molding process using the molding tool (9), wherein the housing frame (4) has at least one exterior side surface (4S) not being covered by the mold material (2M, 2F) .

14. The method according to claim 13,
wherein the mold material (2M, 2F) comprises a matrix material (2M) and fillers (2F) embedded therein, and the matrix material (2M) containing the fillers (2F) has a higher viscosity than the matrix material (2M) without the fillers (2F) .

15. The method according to claim 13 or 14,
wherein applying the mold material (2M, 2F) directly onto the module component (3) and in top view, completely covering the module component (3), and
wherein in a top view, partially forming a front side (10A) of the power semiconductor module (10) by a surface of the encapsulation body (2).
